# EUROPÄISCHE PATENTSCHRIFT

(11) **EP 1 056 165 B1**
(45) Veröffentlichungstag und Bekanntmachung des Hinweises auf die Patenterteilung: **25.04.2007**
(21) Anmeldenummer: 00110405.8
(22) Anmeldetag: 16.05.2000
(51) Int. Cl.: H01R 31/00, H05K 5/02

(54) **Verteiler zum Verbinden von Aktoren und/oder Sensoren**
Distributor for connecting actuators and/or sensors
Bloc répartiteur pour connecter des actionneurs ou des capteurs

(30) Priorität: 28.05.1999 DE 29909205 U; 28.05.1999 DE 29909204 U
(43) Veröffentlichungstag der Anmeldung: 29.11.2000
(73) Patentinhaber: Weidmüller Interface GmbH & Co., D-32758 Detmold (DE)
(72) Erfinder: Wieneke, Andreas, 32657 Lemgo (DE); Reker, Stefan, 33659 Bielefeld (DE)
(74) Vertreter: Specht, Peter

(56) Entgegenhaltungen:
- EP-A- 0 909 121
- DE-A- 4 412 270
- DE-A- 4 437 316
- DE-C- 19 716 137

## Beschreibung

Die Erfindung betrifft einen aktiven oder passiven Verteiler zum Verbinden von Aktoren und/oder Sensoren mit wenigstens einem externen elektrischen Gerät, insbesondere mit einer Steuerungseinheit wie einem PC oder einer SPS, wobei der Verteiler folgendes aufweist: einen ersten Anschlußbereich zum Anschluß der Aktoren und/oder Sensoren an den Verteiler, und einen an den ersten Anschlußbereich angrenzenden zweiten Anschlußbereich zum Anschluß wenigstens eines Anschlußkabels für die Versorgung der Aktoren und/oder Sensoren und/oder zur Weiterleitung der Aktor-/Sensorsignale zwischen den Aktoren/Sensoren und dem elektrischen Gerät.

Ein Verteiler der gattungsgemäßen Art ist aus der EP 0 909 121 A2 bekannt. Der aus dieser Schrift bekannte Verteiler hat den Nachteil, daß eine Erhöhung der Anzahl von Anschlüssen für die Aktoren oder Sensoren aufgrund der gewählten Anordnung der Anschlüsse auch eine deutliche Vergrößerung des Bauraumes des Verteilers bedingt, da die Anschlüsse auf einer der Außenflächen des Verteilers eng zusammenliegen. Zwar kann der erste Anschlußbereich zum Anschluß der Aktoren und Sensoren um 90° gedreht werden, was es ermöglicht, die Stecker der Aktoren und Sensoren aus zwei um 90° voneinander verschiedenen Richtungen anzustecken. Dennoch bewirkt auch die Möglichkeit des Drehens des Anschlußbereiches keine Möglichkeit zur Erhöhung der Anschlußdichte bzw. der max.möglichen Anzahl von Anschlüssen auf dem Anschlußbereich bzw. Anschlußblock. Dies liegt daran, daß die Handhabung des Modules in nicht akzeptabler Weise erschwert würde, wenn die Steckeranschlüsse einfach enger zusammengerückt würden. Ein weiteres Problem des gattungsgemäßen Standes liegt darin begründet, daß keine zufriedenstellende Lösung für die Aufgabe gefunden wurde, das Anschlußgehäuse für das Kabel zum elektrischen Gerät leicht an verschiedenste Einbau- und Ausrichtungserfordernisse anpassen zu können.

Die Erfindung zielt daher darauf ab, einen Verteiler zu schaffen, der bei geringem Bauraumbedarf mit einer hohen Anzahl von gut zugänglichen Anschlüsssen versehbar ist.

Die Erfindung erreicht dieses Ziel durch den Gegenstand des Anspruches 1. Danach ist der wenigstens eine erste Anschlußbereich als Anschlußblock mit mehreren zueinander winklig ausgerichteten Anschlußsegmenten ausgebildet, auf denen die Anschlüsse für die Aktoren oder Sensoren wenigstens teilweise winklig zueinander angeordnet sind. Besonders bevorzugt sind die Anschlußsegmente stumpfwinklig zueinander ausgerichtet. Die Ausbildung des Anschlußblockes mit mehreren zueinander winkligen Anschlußsegmenten oder wenigstens einem Anschlußsegment mit abgerundeter Oberfläche erlaubt eine deutliche Erhöhung der auf dem Anschlußblock unterbringbaren Anschlüsse. Dabei wird auch gewährleistet, daß die in den Anschlüssen zu verriegelnden Stecker gut handhabbar bleiben, denn da die Anschlüsse winklig zueinander ausgerichtet sind, gilt dies auch für die in die Anschlüsse eingesteckten Stecker, die vorzugsweise stumpfwinklig zueinander in einem Winkel "auseinanderlaufen", der größer als 90° und kleiner als 180° ist.

Die Unterteilung des Gehäuses in eine Vielzahl von mit Anschlüssen versehenen Anschlußsegmenten ermöglicht auch das problemlose Anbringen von Markierungen oder Anzeigen (z.B. Leuchtdioden) auf den Flächen der Anschlußsegmente, insbesondere wenn die Segmente stumpfwinklig zueinander ausgerichtet sind, so daß die für die Anschlüsse zur Verfügung stehende Oberfläche des Anschlußblockes gegenüber einer einzigen Rechteckfläche deutlich erhöht wird.

Eine besonders gute Handhabbarkeit des Verteilers wird gewährleistet, wenn auf jedem der Anschlußsegmente jeweils nur einer der Anschlüsse oder nur eine einzige Reihe nebeneinander liegender Anschlüsse angeordnet ist. Der Anschlußblock wird vorzugsweise in so viele Segmente aufgeteilt wie möglich, da die Handhabung der in die Anschlüsse einzubringenden Stecker um leichter wird, je größer die Winkel zwischen den einzelnen Steckern sind. Vorzugsweise schliessen die Anschlußsegmente jeweils einen Winkel von ca. 30 bis 60°, vorzugsweise 45°, mit der Grundfläche des Anschlußblockes ein.

Zur Lösung des Problems, das Anschlußgehäuse für das Kabel zum elektrischen Gerät leicht an verschiedenste Einbau- und Ausrichtungserfordernisse anpassen zu können, weist das Anschlußgehäuse der Erfindung eine Kabelzu- bzw. durchführung - vorzugsweise als rohrförmiger Ansatz ausgebildet - zum Durchführen des Anschlußkabels in das Innere des Anschlußgehäuses auf, die am Anschlußgehäuse beweglich angeordnet ist. Durch die bewegliche Anordnung ist es nicht mehr erforderlich, für verschiedene Ausrichtungen des Anschlußkabels verschiedene Gehäusearten herzustellen. Es ist auch nicht mehr erforderlich, das Anschlußgehäuse relativ zum Anschlußblock umzustecken.

Nach einer Variante der Erfindung ist der (rohrartige) Ansatz am Anschlußgehäuse auf einem Kreisbogenabschnitt verschwenkbar geführt. Diese Variante der Erfindung eignet sich insbesondere für einen Verteiler, dessen Anschlußgehäuse mit zwei oder mehr Anschlußblöcken versehen ist. Die Verschwenkbarkeit des Ansatzes ermöglicht eine Ausrichtung in einem Kreisbogenabschnitt von z.B. 90° und mehr und damit die Zugänglichkeit von zwei der Gehäuseseiten ohne angesetzten Anschlußblock.

Nach einem weiteren vorteilhaften Ausführungsbeispiel der Erfindung weist das Anschlußgehäuse mehrere gegeneinander verdrehbare Abschnitte auf, so daß die Orientierung des rohrartigen Ansatzes relativ zur Grundfläche des Verteilers mehrfach verstellbar ist. Durch die mehrfache Verstellbarkeit kann der rohrartige Ansatz in quasi jeder beliebigen Winkelstellung ausgerichtet werden, so daß der Verteiler optimal an jede Einbaugegebenheit angepaßt werden kann.

Gerade auch die Kombination aus beweglicher Kabeldurchführung und Anschlußblock mit hoher Anschlußdichte schafft einen Verteiler, der besonders vielseitig und platzsparend einsetzbar ist.

Weitere vorteilhafte Ausgestaltungen der Erfindung sind den übrigen Unteransprüchen zu entnehmen.

Nachfolgend wird die Erfindung unter Bezug auf die Zeichnung anhand von Ausführungsbeispielen näher beschrieben. Es zeigt:
- Fig. 1: ein erstes Ausführungsbeispiel der Erfindung;
- Fig. 2: das Ausführungsbeispiel aus Fig. 1 mit einem abgenommenen Gehäuseabschnitt;
- Fig. 3 bis 5: verschiedene Betriebsstellungen eines dritten Ausführungsbeispiels der Erfindung;
- Fig. 6: ein viertes Ausführungsbeispiel der Erfindung;
- Fig. 7 und 8: verschiedene Betriebsstellungen eines fünften Ausführungsbeispiels der Erfindung.

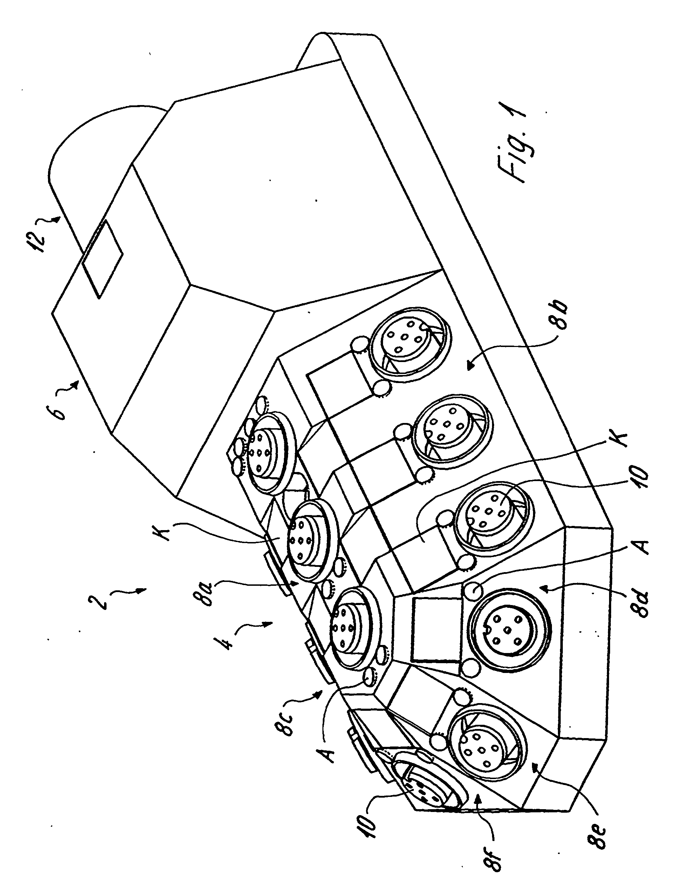

Fig. 1 zeigt einen Verteiler 2 zum Verbinden von (hier nicht dargestellten) Aktoren und/oder Sensoren mit wenigstens einem externen elektrischen Gerät (hier ebenfalls nicht dargestellt). Dieses externe Gerät kann beispielsweise eine Steuerungseinheit wie ein PC oder eine SPS sein.

Der Verteiler 2 weist einen als Anschlußblock 4 ausgebildeten ersten Anschlußbereich zum Anschluß der Aktoren und/oder Sensoren an den Verteiler 2 auf sowie ein an den Anschlußblock 4 direkt angesetztes Anschlußgehäuse 6 als Anschlußbereich zum Anschluß wenigstens eines (hier ebenfalls nicht dargestellten) Anschlußkabels für die Versorgung der Aktoren und/oder Sensoren und/oder zur Weiterleitung der Aktor-/Sensorsignale zum und vom elektrischen Gerät.

Der Anschlußblock 4 ist mit mehreren zueinander winklig ausgerichteten Anschlußsegmenten 8a, 8 b, 8c, ... versehen, auf denen die Anschlüsse 10 (z.B. in M8 oder M10-Technik ausgeführt) für die Aktoren oder Sensoren angeordnet sind. Der Anschlußblock 4 des Verteilers weist eine anschlußfreie - in der Einbaustellung der Fig. 1 "untere" - Grundfläche auf, zu der das erste Anschlußsegment 8a parallel ausgerichtet ist. Die weiteren Anschlußsegmente 8b, 8c liegen im spitzen Winkel zur Grundfläche und im stumpfen Winkel zum ersten Anschlußsegment 8a, so daß der Anschlußblock 4 in einem seiner Querschnitte im wesentlichen eine Trapezform aufweist. Auf jedem der vorstehend beschriebenen drei Anschlußsegmente 8a - 8c sind jeweils drei der Anschlüsse 10 in einer Reihe nebeneinander angeordnet. An das vom Anschlußgehäuse 6 abgewandte axiale Ende des länglichen Anschlußblockes 4 sind drei weitere Anschlußsegmente 8d, 8e, 8f angeformt, die jeweils miteinander einen stumpfen Winkel und mit der Grundfläche jeweils einen spitzen Winkel einschliessen, die mit nur einem der Anschlüsse 10 versehen sind und die den Anschlußblock 4 im wesentlichen spitz zulaufend axial abschliessen.

Jeder Anschluß 10 der Anschlußsegmente 8 des Anschlußblockes 4 ist hervorragend zugänglich. Durch die Anordnung der Anschlüsse 10 auf zueinander stumpfwinkligen Anschlußsegmenten 8 wird zudem eine hohe Dichte von Anschlüssen 10 auf engem Raum realisiert, die möglich wird, da die Stecker winklig zueinander ausgerichtet sind und damit zumindest an ihren von den Anschlüssen abgewandten Enden nicht so eng zusammenstehen wie dies in einer einzigen Anschlußebene der Fall wäre. Insbesondere in der mittleren Reihe wären die Anschlußstecker bei der Anordnung der Stecker in nur einer Ebene quasi nicht mehr handhabbar. Darüberhinaus ermöglicht die stumpfwinklige Asurichtung des Anschlußsegmente 8 zueinander durch die besonders große Oberfläche des Anschlußblockes 4 ein leichtes Anbringen von Kennzeichnungsfeldern K und Anzeigedioden A.

Das zweite axiale Ende des Anschlußblockes 4 grenzt an das Anschlußgehäuse 6 an, welches einen im wesentlichen trapezförmigen Querschnitt hat und eine Gehäuseöffnung zum Durchführen des wenigstens einen zum elektrischen Gerät führenden Anschlußkabels für die Versorgung der Aktoren und/oder Sensoren aufweist, an welche ein rohrartiger Ansatz 12 zum Durchführen des Anschlußkabels mit Steckanschluß in das Innere des Anschlußgehäuses angeformt ist. Das Gehäuse 6 kann optional zur Aufnahme einer hier nicht dargestellten Elektronik dienen (aktiver Verteiler).

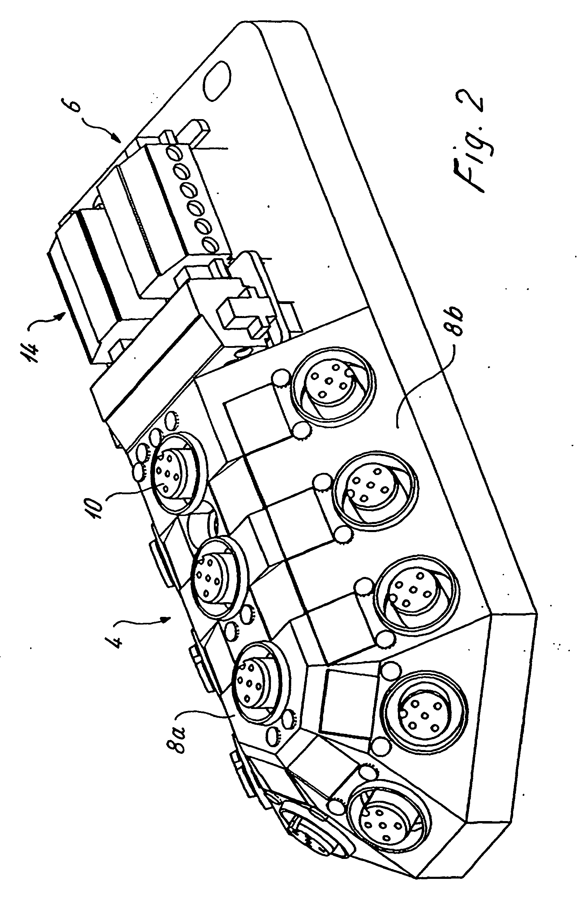

Fig. 2 unterscheidet sich von der Version der Fig. 1 dadurch, daß der Verteiler mit abgenommenem Anschlußgehäuse dargestellt wird. Zu erkennen sind die Anschlußstecker 14 für den Anschluß des externen Kabels.

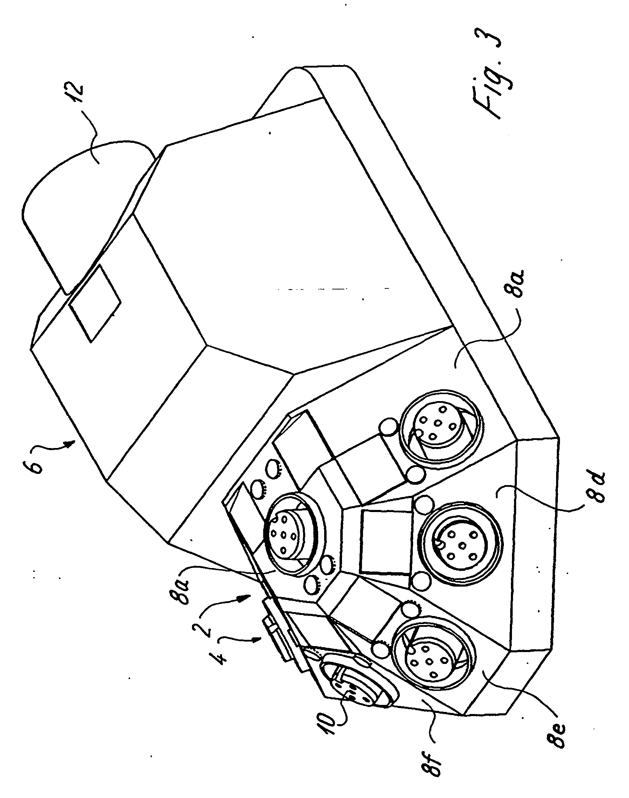

Das Ausführungsbeispiel der Fig. 3 entspricht hinsichtlich seiner prinzipiellen Funktion dem Ausführungsbeispiel der Fig. 1 und 2, allerdings sind die Anschlußsegmente 8a, 8b und 8c jeweils nur mit einem einzigen Anschluß 10 versehen. Dieser Verteiler ist besonders kompakt ausgebildet, wobei die Anschlüsse 10 zueinander winklig angeordnet ist, so daß eine besonders gute Zugänglichkeit zu allen Anschlüssen gewährleistet wird.

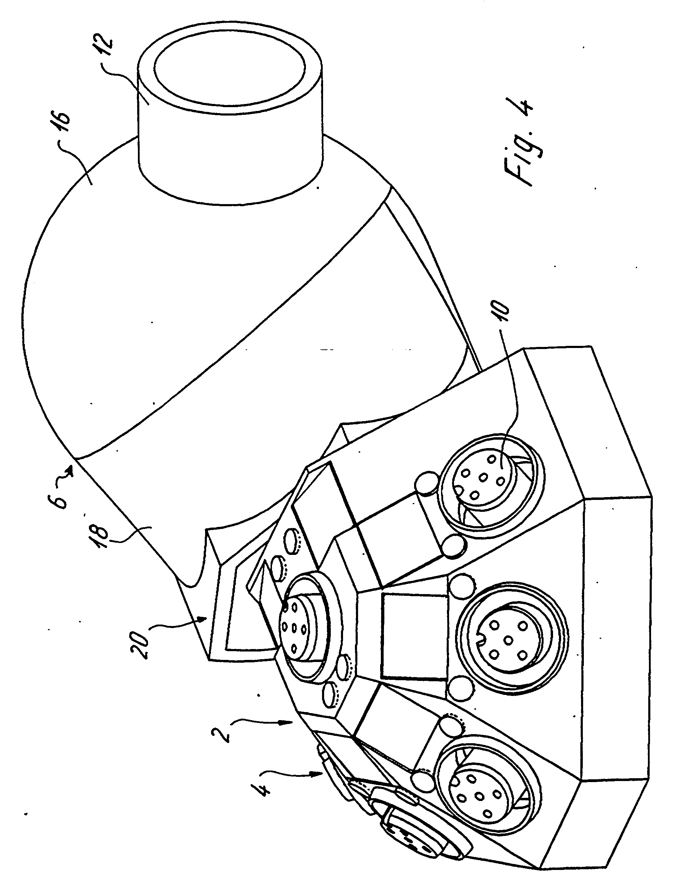

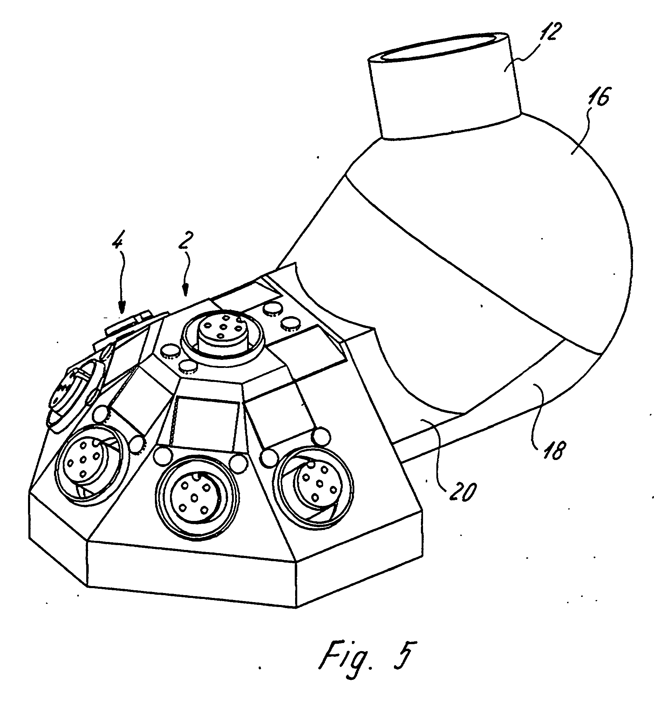

Das Ausführungsbeispiel der Fig. 4 entspricht hinsichtlich des Aufbaus des Anschlußblockes dem Ausführungsbeispiel der Fig. 3. In Fig. 4 wurde allerdings eine Lösung gewählt, bei welcher der rohrartige Ansatz 12 am Elektronikgehäuse 6 verschwenkbar angeordnet ist. Dazu ist der rohrartige Ansatz 12 an einer Art Halbkugelschale 16 angeordnet, die an einem zylindrischen Gehäuseabschnitt 18 (um nahezu 360°) 18 verdrehbar gelagert ist. Der Gehäuseabschnitt 18 ist wiederum mit einem Ansatz 20 versehen, welcher eine im wesentlichen ebene Grundseite aufweist, welche an der ebenen Außenfläche des Anschlußblockes 4 anliegt und an dieser verdrehbar gelagert ist. Da die beiden Drehachsen (die erste zwischen der Halbkugelschale 16 und dem Gehäuseabschnitt 18 sowie die zweite zwischen dem Ansatz 20 und der gegenüberliegenden axialen Anschlußblockseite) winklig zueinander ausgerichtet sind, ist es möglich, den rohrartigen Ansatz 12 optimal entsprechend zur Einbausituation im Raum zu verstellen. Zwei verschiedene mögliche Ausrichtungen des rohrartigen Ansatzes 12 veranschaulichen die Fig. 4 und 5.

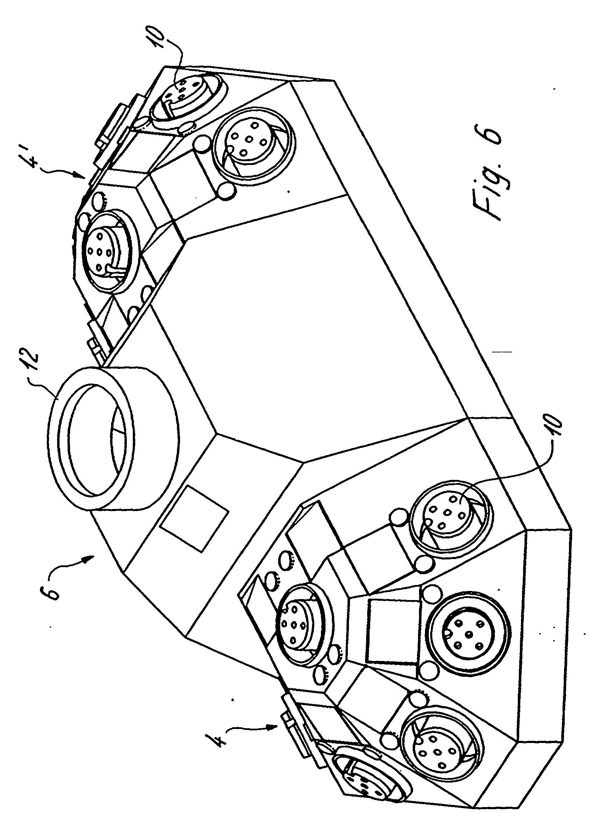

Fig. 6 entspricht hinsichtlich des Aufbaus des ersten Anschlußblockes 4 dem Ausführungsbeispiel der Fig. 3. Anders als in Fig. 3 wird allerdings an die dem ersten Anschlußblock gegenüberliegende Stirnseite des Anschluß- und/oder Elektronikgehäuses 6 ein zweiter Anschlußblock 4' angesetzt, dessen Aufbau dem des ersten Anschlußblockes 4 entspricht. Der rohrartige Ansatz 12 des Elektronikgehäuses 6 zeigt senkrecht nach oben, andere Ausrichtungen des rohrartigen Ansatzes sind ebenfalls (bei der Herstellung) realisierbar. Dieser Verteiler 2 mit zwei Anschlußblöcken realisiert eine besonders hohe Anschlußdichte bei geringen Abmessungen und hervorragender Handhabbarkeit.

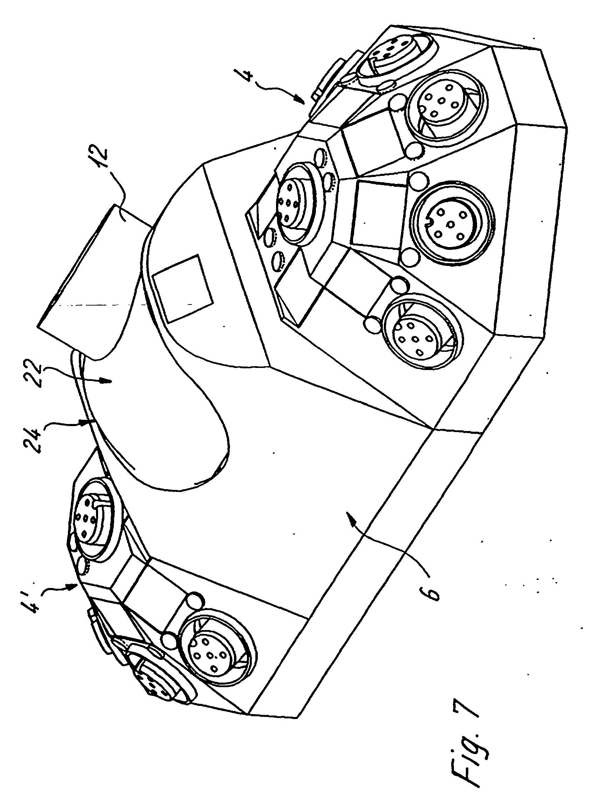

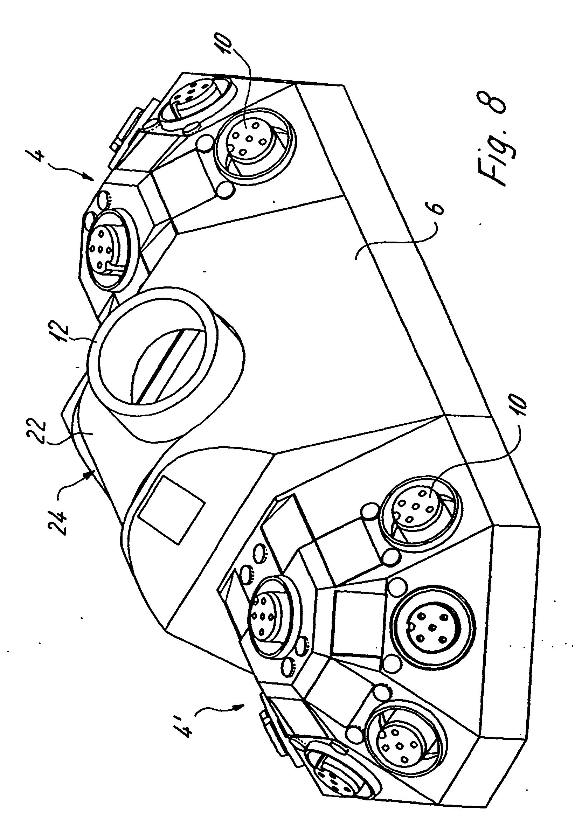

Um ein einfaches, bedarfsorientiertes Ausrichten des rohrartigen Ansatzes 12 bei dem Verteiler mit zwei Anschlußblöcken zu ermöglichen, ist dieser nach dem Ausführungsbeispielen der Fig. 7 und 8 auf einem Schiebelement 22 angeordnet, welches eine Bogenform aufweist und in einer bogenförmigen Ausnehmung 24 (mit hier nicht dargestellten Führungselementen für das Schiebeelement 22) verschwenkt werden kann. Vorzugsweise wird ein Verschwenkbereich von mehr als 60° realisiert.

### Bezugszeichen

- Verteiler: 2
- Anschlußblock: 4
- Anschlußgehäuse: 6
- Anschlußsegmente: 8a, 8 b, 8c, ...
- Anschlüsse: 10
- rohrartiger Ansatz: 12
- Anschlußstecker: 14
- Halb kugelschale: 16
- Gehäuseabschnitt: 18
- Ansatz: 20
- Schiebeelement: 22
- Ausnehmung: 24
- Kennzeichnungsfelder: K
- Anzeigedioden: A

## Patentansprüche

1. Aktiver oder passiver Verteiler zum Verbinden von Aktoren und/oder Sensoren mit wenigstens einem externen elektrischen Gerät, insbesondere mit einer Steuerungseinheit wie einem PC oder einer SPS, wobei der Verteiler folgendes aufweist:
- wenigstens einen ersten als Anschlußblock ausgebildeten Anschlußbereich (4) zum Anschluß der Aktoren und/oder Sensoren an den Verteiler (2), und
- einen an den ersten Anschlußbereich (4) angrenzenden zweiten Anschlußbereich (6) zum Anschluß wenigstens eines Anschlußkabels für die Versorgung der Aktoren und/oder Sensoren und/oder zur Weiterleitung der Aktor-/Sensorsignale zwischen den Aktoren/Sensoren und dem externen elektrischen Gerät,
**dadurch gekennzeichnet, daß**
- der wenigstens eine Anschlußblock (4) mehrere zueinander winklig ausgerichtete Anschlußsegmente (8) oder wenigstens ein Anschlußsegment mit abgerundeter Oberfläche aufweist, auf denen/dem die Anschlüsse (10) für die Aktoren oder Sensoren wenigstens teilweise winklig zueinander angeordnet sind.

2. Verteiler nach Anspruch 1, **dadurch gekennzeichnet, daß** die Anschlußsegmente (8) und/oder die Anschlüsse (10) im wesentlichen stumpfwinklig zueinander ausgerichtet sind.

3. Verteiler nach Anspruch 1 oder 2, **dadurch gekennzeichnet, daß** der Anschlußblock (4) des Verteilers eine anschlußfreie Grundfläche, ein im wesentlichen zur Grundfläche parallel ausgerichtetes erstes Anschlußsegment (8a) sowie zwei im spitzen Winkel zur Grundfläche liegende weitere Anschlußsegmente (8b, 8c) aufweist, so daß der Anschlußblock (4) in einem seiner Querschnitte im wesentlichen eine Trapezform aufweist.

4. Verteiler nach Anspruch 1, 2 oder 3, **dadurch gekennzeichnet, daß** der zweite Anschlußbereich als Anschlußgehäuse (6) ausgebildet ist, welches an den wenigstens einen Anschlußblock (4) angrenzt und eine Gehäuseöffnung zum Durchführen des wenigstens einen zum elektrischen Gerät führenden Anschlußkabels für die Versorgung der Aktoren und/oder Sensoren und/oder zur Weiterleitung der Aktor-/Sensorsignale aufweist.

5. Verteiler nach einem der vorstehenden Ansprüche, **dadurch gekennzeichnet, daß** auf jedem der Anschlußsegmente (8) jeweils nur einer der Anschlüsse (10) oder eine Reihe nebeneinanderliegender Anschlüsse (10) angeordnet ist.

6. Verteiler nach einem der vorstehenden Ansprüche, **dadurch gekennzeichnet, daß** der wenigstens eine Anschlußblock (4) an einem seiner axialen Enden an das Anschlußgehäuse (6) angrenzt.

7. Verteiler nach einem der vorstehenden Ansprüche, **dadurch gekennzeichnet, daß** an das vom Anschlußgehäuse (6) abgewandte axiale Ende des Anschlußblockes (4) wenigstens ein weiteres Anschlußsegment (8d, 8e, 8f) angesetzt oder angeformt ist.

8. Verteiler nach einem der vorstehenden Ansprüche, **dadurch gekennzeichnet, daß** die an das axiale Ende des Anschlußblockes angeformten weiteren Anschlußsegmente (8) miteinander jeweils einen stumpfen Winkel und mit der Grundfläche jeweils einen spitzen Winkel einschliessen und den Anschlußblock im wesentlichen spitz zulaufend axial abschliessen.

9. Verteiler nach einem der vorstehenden Ansprüche, **dadurch gekennzeichnet, daß** die Anschlußsegmente jeweils einen Winkel von ca. 30 bis 60°, vorzugsweise 45°, mit der Grundfläche einschliessen.

10. Verteiler nach einem der vorstehenden Ansprüche, **dadurch gekennzeichnet, daß** das Anschlußgehäuse an zwei einander gegenüberliegenden Außenflächen jeweils mit einem der Anschlußblöcke (4) versehen ist.

11. Verteiler nach dem Oberbegriff des Anspruches 1 oder nach einem der vorstehenden Ansprüche, **dadurch gekennzeichnet, daß** das Anschlußgehäuse (6) eine Durchführung zum Durchrühren des Anschlußkabels in das Innere des Anschlußgehäuses (6) aufweist, die/der am Anschlußgehäuse (6) beweglich angeordnet ist.

12. Verteiler nach Anspruch 11, **dadurch gekennzeichnet, daß** die Durchführung mit einem Ansatz (12) versehen ist.

13. Verteiler nach Anspruch 12, **dadurch gekennzeichnet, daß** der Ansatz (12) rohrartig ausgelegt und am Anschlußgehäuse verschieblich geführt ist.

14. Verteiler nach einem der vorstehenden Ansprüche, **dadurch gekennzeichnet, daß** der rohrartige Ansatz (12) am Anschlußgehäuse auf einem Kreisbogenabschnitt verschwenkbar geführt ist.

15. Verteiler nach einem der vorstehenden Ansprüche, **dadurch gekennzeichnet, daß** das Anschlußgehäuse (6) mehrere gegeneinander verdrehbare Abschnitte (16, 18) aufweist, so daß die Orientierung des rohrartigen Ansatzes (12) relativ zur Grundfläche des Verteilers (2) mehrfach verstellbar ist.

## Claims

1. Active or passive distributor for connecting actuators and/or sensors to at least one external electric device, in particular to a control unit such as a PC or a PLC, the distributor comprising:
- at least one first connecting area (4) designed as a connecting block for connecting the actuators and/or sensors to the distributor (2), and
- a second connecting area (6) adjoining the first connecting area (4) for connecting at least one connecting cable for the supply of the actuators and/or sensors and/or for forwarding the actuator/sensor signals between the actuators/sensors and the external electric device,
**characterised in that**
- the at least one connecting block (4) comprises a plurality of connecting segments (8) aligned at an angle relative to one another or at least one connecting segment with a rounded surface, whereon the connections (10) for the actuators or sensors are at least partially arranged at an angle relative to one another.

2. Distributor according to claim 1, **characterised in that** the connecting segments (8) and/or the connections (10) are aligned substantially at an obtuse angle relative to one another.

3. Distributor according to claim 1 or 2, **characterised in that** the connecting block (4) of the distributor comprises a connection-free base surface, a first connecting segment (8a) aligned substantially parallel to the base surface and two further connecting segments (8b, 8c) extending at an acute angle relative to the base surface, so that the connecting block (4) has a substantially trapezoidal cross-section.

4. Distributor according to claim 1, 2 or 3, **characterised in that** the second connecting area is designed as a connection housing (6) adjoining the at least one connecting block (4) and having a housing opening for the passage of the at least one connecting cable leading to the electric device for the supply of the actuators and/or sensors and/or for forwarding the actuator/sensor signals

5. Distributor according to any of the preceding claims, **characterised in that** only one of the connections (10) or a row of adjacent connections (10) is located on each of the connecting segments (8).

6. Distributor according to any of the preceding claims, **characterised in that** one of the axial ends of the at least one connecting block (4) adjoins the connection housing (6).

7. Distributor according to any of the preceding claims, **characterised in that** at least one further connecting segment (8d, 8e, 8f) is fitted to or integrated with the axial end of the connecting block (4) which is remote from the connection housing (6).

8. Distributor according to any of the preceding claims, **characterised in that** the further connecting segments (8) integrated with the axial end of the connecting block enclose an obtuse angle with one another and an acute angle with the base surface and axially terminate the connecting block in a substantially tapering formation.

9. Distributor according to any of the preceding claims, **characterised in that** the connecting segments enclose an angle of 30 to 60°, preferably 45°, with the base surface.

10. Distributor according to any of the preceding claims, **characterised in that** the connection housing is fitted with one of the connecting blocks (4) on each of its opposite external surfaces.

11. Distributor according to the preamble of claim 1 or to any of the preceding claims, **characterised in that** the connection housing (6) comprises a bushing for the passage of the connecting cable into the interior of the connection housing (6), which is arranged to be movable on the connection housing (6).

12. Distributor according to claim 11, **characterised in that** the bushing is provided with a projection (12).

13. Distributor according to claim 12, **characterised in that** the projection (12) is tubular and guided for movement on the connection housing.

14. Distributor according to any of the preceding claims, **characterised in that** the tubular projection (12) is pivotably guided on the connection housing on an arc section.

15. Distributor according to any of the preceding claims, **characterised in that** the connection housing (6) comprises a plurality of sections (16, 18) rotatable against one another, so that the orientation of the tubular projection (12) can be adjusted in multiple ways relative to the base surface of the distributor (2).

## Revendications

1. Distributeur actif ou passif pour le raccordement d'actionneurs et/ou de capteurs avec au moins un appareil électrique externe, en particulier avec une unité de commande telle qu'un PC ou une commande par programme enregistré, le distributeur comportant :
- au moins une première zone de raccordement (4) conçue comme un bloc de raccordement pour le raccordement des actionneurs et/ou des capteurs au distributeur (2), et
- une deuxième zone de raccordement (6) contiguë à la première zone de raccordement (4) pour le raccordement d'au moins un câble de raccordement pour l'alimentation des actionneurs et/ou des capteurs et/ou pour la transmission des signaux des actionneurs/capteurs entre les actionneurs /capteurs et l'appareil électrique externe,
**caractérisé en ce que**
- le bloc de raccordement (4) au nombre d'un au moins comporte plusieurs segments de raccordement (8) orientés de manière angulaire les uns par rapport aux autres ou au moins un segment de raccordement avec une surface arrondie sur lesquels/lequel les raccords (10) pour les actionneurs ou les capteurs sont disposés au moins partiellement de manière angulaire les uns par rapport aux autres.

2. Distributeur selon la revendication 1, **caractérisé en ce que** les segments de raccordement (8) et/ou les raccords (10) sont orientés sensiblement à angle obtus les uns par rapport aux autres.

3. Distributeur selon la revendication 1 ou 2, **caractérisé en ce que** le bloc de raccordement (4) du distributeur comporte une surface de base sans raccord, un premier segment de raccordement (8a) orienté sensiblement parallèlement à la surface de base ainsi que de deux autres segments de raccordement (8b, 8c) disposés à angle aigu par rapport à la surface de base, de sorte que le bloc de raccordement (4) présente une forme sensiblement trapézoïdale dans l'une de ses sections transversales.

4. Distributeur selon la revendication 1, 2 ou 3, **caractérisé en ce que** la deuxième zone de raccordement est conçue comme un boîtier de raccordement (6) qui est adjacent à un bloc de raccordement (4) au nombre d'un au moins et qui comporte une ouverture de raccordement pour le passage du câble de raccordement au nombre d'un au moins conduisant à l'appareil électrique pour l'alimentation des actionneurs et/ou des capteurs et/ou pour la transmission des signaux des actionneurs/capteurs.

5. Distributeur selon l'une des revendications précédentes, **caractérisé en ce que** seulement l'un des raccords (10) ou une rangée de raccords (10) disposés les uns à côté des autres est respectivement disposé(e) sur chacun des segments de raccordement (8).

6. Distributeur selon l'une des revendications précédentes, **caractérisé en ce que** le bloc de raccordement (4) au nombre de un au moins est adjacent au boîtier de raccordement (6) à l'une de ses extrémités axiales.

7. Distributeur selon l'une des revendications précédentes, **caractérisé en ce qu'**au moins un autre segment de raccordement (8d, 8e, 8f) est fixé ou surmoulé à l'extrémité axiale du bloc de raccordement (4) opposée au boîtier de raccordement (6).

8. Distributeur selon l'une des revendications précédentes, **caractérisé en ce que** les autres segments de raccordement (8) surmoulés à l'extrémité axiale du bloc de raccordement forment un angle obtus les uns avec les autres et forment un angle aigu avec la surface de base et obturent le bloc de raccordement sensiblement axialement en se terminant en pointe.

9. Distributeur selon l'une des revendications précédentes, **caractérisé en ce que** les segments de raccordement forment chacun un angle d'environ 30° à 60°, de préférence de 45°, avec la surface de base.

10. Distributeur selon l'une des revendications précédentes, **caractérisé en ce que** le boîtier de raccordement est muni de l'un des blocs de raccordement (4) sur deux surfaces extérieures opposées.

11. Distributeur selon le préambule de la revendication 1 ou selon l'une des revendications précédentes, **caractérisé en ce que** le boîtier de raccordement (6) comporte une voie de passage pour le passage du câble de raccordement à l'intérieur du boîtier de raccordement (6), qui est disposée de manière mobile sur le boîtier de raccordement (6).

12. Distributeur selon la revendication 11, **caractérisé en ce que** la voie de passage est munie d'un épaulement (12).

13. Distributeur selon la revendication 12, **caractérisé en ce que** l'épaulement (12) est conçu à la manière d'un tube et est guidé de manière à coulisser sur le boîtier de raccordement.

14. Distributeur selon l'une des revendications précédentes, **caractérisé en ce que** l'épaulement (12) conçu à la manière d'un tube est guidé de manière à pouvoir pivoter sur un segment d'arc de cercle sur le boîtier de raccordement.

15. Distributeur selon l'une des revendications précédentes, **caractérisé en ce que** le boîtier de raccordement (6) comporte plusieurs tronçons (16, 18) rotatifs l'un par rapport à l'autre, de sorte que l'orientation de l'épaulement (12) conçu à la manière d'un tube est réglable de manière multiple par rapport à la surface de base du distributeur (2).
